# EUROPEAN PATENT APPLICATION

(11) **EP 1 538 663 A2**
(43) Date of publication of application: **08.06.2005**
(21) Application number: 04027591.9
(22) Date of filing: 19.11.2004
(51) Int. Cl.: H01L 21/3065, H01L 21/304, H01L 21/316, H01L 21/00, B24B 7/22

(54) **Wafer backside processing method and corresponding processing apparatus**

(30) Priority: 02.12.2003 JP 2003403247
(71) Applicant: TOKYO SEIMITSU CO.,LTD., Mitaka-shi Tokyo (JP)
(72) Inventor: Kawashima, Isamu, Mitaka-shi Tokyo (JP)
(74) Representative: Rackham, Stephen Neil

(57) **Abstract**

There are provided a wafer processing method comprising the steps of grinding an underside (21) of a wafer which is provided, on its front surface (29), with a plurality of semiconductor devices (10); polishing a ground surface (22) formed by the grinding operation; and carrying out a plasma-processing for a polished surface (23) formed by the polishing operation under a predetermined gaseous atmosphere in a plasma chamber, to form an oxide layer on the polished surface, and a wafer processing method comprising the steps of carrying out a first plasma-processing for a polished surface formed by the polishing operation under a first gaseous atmosphere (CF₄ or SF₆) in a plasma chamber, to clean the polished surface; and carrying out a second plasma-processing for the polished surface after the cleaning operation under a second gaseous atmosphere (O₂) in the plasma chamber, to form an oxide layer on the polished surface, and a wafer processing apparatus for carrying out these methods. Thus, the wafer can be processed while the occurrence of an electrical failure in a thin wafer is restricted.

## Description

### BACKGROUND OF THE INVENTION

### 1. Field of the Invention

The present invention relates to method and apparatus for processing a wafer when a semiconductor is manufactured.

### 2. Description of the Related Art

In the semiconductor manufacturing field, the size of a wafer tends to increase year after year. In order to improve a packing density, the thickness of a wafer tends to be reduced. In order to reduce the thickness of a wafer, an underside grinding operation is carried out, i.e., a surface protection tape is adhered to a front surface of a wafer, on which semiconductor devices are formed, to draw and hold the wafer and, then, the underside of the wafer is ground. However, as the thickness of a wafer is reduced, it is more difficult to handle the wafer, and the reliability of a chip mounting operation, after the wafer is cut into chips, is reduced. Accordingly, the ground surface (underside) obtained after the underside grounding operation is carried out, is polished, so that a fracture layer occurring on the ground surface, in the underside grounding operation, is removed.

In some cases, a plasma-processing operation is carried out on a wafer when a semiconductor is manufactured. In Japanese Unexamined Patent Publication (Kokai) No. 5-182935, Kokai No. 5-299385, Kokai No. 8-167595, Kokai No. 9-293876, Kokai No. 11-260793, WO98/33362, Kokai No. 2000-216140, Kokai No. 2001-127016, Kokai No. 2001-160551, Japanese Examined Patent Publication (Kokoku) No. 7-111965, Japanese Patent No. 2534098, Japanese Patent No. 2594448, Japanese Patent No. 2673526, Japanese Patent No. 3093445 and Japanese Patent No. 3231202, various plasma devices used when a semiconductor is manufactured or various processing methods of a wafer to be plasma-processed are disclosed.

Usually, in order to improve the level of cleanliness of a wafer, for example, a gettering method, in which the level of cleanliness of a device active region on the front surface of a wafer is maintained by forming a site to collect heavy metal pollutants on the underside of the wafer, is adopted. However, as described above, if the thickness of a wafer is reduced, it is necessary to provide a process, subsequent to the grinding process, in which a layer damaged by grinding is removed. Accordingly, the effect of the gettering cannot be expected, and ion contamination sometimes occurs. Especially, in recent years, a further reduction in the thickness of a wafer is required. Thus, it is difficult to obtain the effect of gettering, and there is a high possibility that an electrical failure may occur due to ion contamination of a manufactured semiconductor.

When dicing a wafer, a dicing tape is applied to the underside of the wafer, and a dicing saw cuts halfway through the dicing tape, from the front surface of the wafer, so that a part of the dicing tape remains and, thus, the separated dies can be prevented from scattering. However, when the dicing tape is directly applied to a polished surface of the wafer immediately after polishing, an adhesion force between the dicing tape and the polished surface is increased because the polished surface is activated. Therefore, it is difficult to pick up the dies from the dicing tape in a die bonding operation.

Further, when a wafer is not sufficiently cleaned, a natural oxide layer having a nonuniform thickness is partly formed on the underside of the wafer. Accordingly, there is a possibility that the underside of the wafer may be mottled in a later thin film forming process due to the above natural oxide layer. In this case, not only a problem of appearance but also a variation in electrical properties of the semiconductor may occur.

Further, when discrete devices are formed from a wafer, it is preferable that a polishing process is adopted to obtain an excellent uniform thickness of the wafer. However, the underside of the wafer is flattened more than necessary after the polishing process. Accordingly, when the polished surface of the wafer is coated with a metal coating in a later metalizing process, an adhesion force between the metal coating and the polished surface of the wafer is reduced, and the metal coating may be stripped.

In view of the above problems, the object of the present invention is to provide a wafer processing method in which a wafer can be processed while the occurrence of an electrical failure is restricted even if the thickness of the wafer is reduced and to provide a wafer processing apparatus in which the wafer processing method is carried out.

### SUMMARY OF THE INVENTION

In order to achieve the above object, according to a first aspect of the present invention, there is provided a wafer processing method comprising the steps of grinding an underside of a wafer which is provided, on its front surface, with a plurality of semiconductor devices; polishing a ground surface formed by the grinding operation; and carrying out a plasma-processing for a polished surface formed by the polishing operation under a predetermined gaseous atmosphere in a plasma chamber, to form an oxide layer on the polished surface.

Namely, in the first aspect of the present invention, the oxide layer is formed on the polished surface on the underside of the wafer and, accordingly, the occurrence of ion contamination can be prevented. Therefore, the wafer can be processed while the occurrence of an electrical failure is restricted even if the thickness of the wafer is reduced. The plasma-processing operation can be carried out immediately after the polishing process. Accordingly, the first aspect is different from a situation when it is necessary to transfer the wafer from a polishing machine to a plasma-processing machine, the mixing of contamination from a polluted atmosphere to the wafer can be prevented and, thus, the occurrence of an electrical failure can be further restricted. Further, in the first aspect, even if the dicing tape is applied, an adhesion force between the dicing tape and the wafer is not extremely large because the oxide layer is formed. Therefore, the difficulty of picking up of dies can be prevented. Also, in the first aspect, the wafer can be prevented from being mottled in a later thin film forming process because the oxide layer can be formed on the entire surface of the wafer. Oxygen is supplied to the plasma chamber to provide an oxygen atmosphere in the plasma-processing operation to form the oxide layer.

According to a second aspect of the present invention, there is provided a wafer processing method comprising the steps of grinding an underside of a wafer which is provided, on its front surface, with a plurality of semiconductor devices; polishing a ground surface formed by the grinding operation; carrying out a first plasma-processing for a polished surface formed by the polishing operation under a first gaseous atmosphere in a plasma chamber, to clean the polished surface; and carrying out a second plasma-processing for the polished surface after the washing operation under a second gaseous atmosphere in the plasma chamber, to form an oxide layer on the polished surface.

Namely, in the second aspect of the present invention, the oxide layer is formed on the polished surface on the underside of the wafer and, accordingly, the occurrence of ion contamination can be prevented. Also, in this case, the oxide layer is more uniform and excellent because the oxide layer is formed after a cleaning operation and, thus, the wafer can be processed while the occurrence of an electrical failure is further restricted even if the thickness of the wafer is reduced. The first and second plasma-processing operations can be carried out immediately after the polishing process, and can be carried out in the same plasma chamber. Accordingly, the second aspect is different from the situation, when it is necessary to transfer the wafer from a polishing machine to a first plasma-processing machine, and from the first plasma-processing machine to a second plasma-processing machine, the mixing of contamination from a polluted atmosphere to the wafer can be prevented and, thus, the occurrence of an electrical failure can be further restricted. Further, in the second aspect, even if the dicing tape is applied, an adhesion force between the dicing tape and the wafer is not extremely large because the oxide layer is formed. Therefore, the difficulty of picking up of dies can be prevented. Also, in the second aspect, the wafer can be prevented from being mottled in a later thin film forming process because the oxide layer can be formed on the entire surface of the wafer. Carbon tetrafluoride (CF₄) or sulfur hexafluoride (SF₆) is supplied to the plasma chamber to provide an atmosphere of CF₄ or SF₆ in the first plasma-processing operation to clean the wafer, and oxygen is supplied to the same plasma chamber to provide an atmosphere of oxygen in the second plasma-processing operation to form the oxide layer.

According to a third aspect of the present invention, there is provided a wafer processing method comprising the steps of grinding an underside of a wafer which is provided, on its front surface, with a plurality of semiconductor devices; polishing a ground surface formed by the grinding operation; and carrying out a plasma-processing for a polished surface formed by the polishing operation under a predetermined gaseous atmosphere in a plasma chamber, to roughen the polished surface.

Namely, in the third aspect of the present invention, the underside of the wafer is appropriately roughened by plasma-processing and, accordingly, a metal coating coated in a later metalizing process bites into the roughed portion. Thus, even on a thin wafer the metal coating can be prevented from being stripped. Carbon tetrafluoride (CF₄) or sulfur hexafluoride (SF₆) is supplied to the plasma chamber to provide an atmosphere of CF₄ or SF₆ in the plasma-processing operation to roughen the surface.

According to a fourth aspect of the present invention, there is provided a wafer processing apparatus comprising grinding means for grinding an underside of a wafer whose front surface has a plurality of semiconductor devices formed thereon; polishing means for polishing a ground surface formed by the grinding means; and plasma-processing means for carrying out a plasma-processing for a polished surface formed by the polishing operation under a predetermined gaseous atmosphere in a plasma chamber, to form an oxide layer on the polished surface.

Namely, in the fourth aspect of the present invention, the oxide layer is formed on the polished surface on the underside of the wafer and, accordingly, the occurrence of ion contamination can be prevented. Therefore, the wafer can be processed while the occurrence of an electrical failure is restricted even if the thickness of the wafer is reduced. The plasma-processing operation can be carried out immediately after the polishing process. Accordingly, the fourth aspect is different from a situation when it is necessary to transfer the wafer from a polishing machine to a plasma-processing machine, the mixing of contamination from a polluted atmosphere to the wafer can be prevented and, thus, the occurrence of an electrical failure can be further restricted. Further, in the fourth aspect, even if the dicing tape is applied, an adhesion force between the dicing tape and the wafer is not extremely large because the oxide layer is formed. Therefore, a difficulty in picking up of dies can be prevented. Also, in the fourth aspect, the wafer can be prevented from being mottled in a later thin film forming process because the oxide layer can be formed on the entire surface of the wafer. Oxygen is supplied to the plasma chamber to provide an atmosphere of oxygen in the plasma-processing operation to form the oxide layer.

According to a fifth aspect of the present invention, there is provided a wafer processing apparatus comprising grinding means for grinding an underside of a wafer whose front surface has a plurality of semiconductor devices formed thereon; polishing means for polishing a ground surface formed by the grinding means; and plasma-processing means in which, after a first plasma-processing is carried out on a polished surface formed by the polishing operation under a first gaseous atmosphere in a plasma chamber, to clean the polished surface, a second plasma-processing is carried out on the polished surface under a second gaseous atmosphere in the plasma chamber, to form an oxide layer on the polished surface.

Namely, in the fifth aspect of the present invention, the oxide layer is formed on the polished surface on the underside of the wafer and, accordingly, the occurrence of ion contamination can be prevented. Also, in this case, the oxide layer is more uniform and excellent because the oxide layer is formed after the cleaning operation and, thus, the wafer can be processed while the occurrence of an electrical failure is further restricted even if the thickness of the wafer is reduced. The first and second plasma-processing operations can be carried out immediately after the polishing process, and can be carried out in the same plasma chamber. Accordingly, the fifth aspect is different from the situation when it is necessary to transfer the wafer from a polishing machine to a first plasma-processing machine, and from the first plasma-processing machine to a second plasma-processing machine, the mixing of contamination from a polluted atmosphere to the wafer can be prevented and, thus, the occurrence of an electric failure can be further restricted. Further, in the fifth aspect, even if the dicing tape is applied, an adhesion force between the dicing tape and the wafer is not extremely large because the oxide layer is formed. Therefore, a difficulty of picking up the dies can be prevented.
Also, in the fifth aspect, the wafer can be prevented from being mottled in a later thin film forming process because the oxide layer can be formed on the entire surface of the wafer. Carbon tetrafluoride (CF₄) or sulfur hexafluoride (SF₆) is supplied to the plasma chamber to provide an atmosphere of CF₄ or SF₆ in the first plasma-processing operation to clean the wafer, and oxygen is supplied to the same plasma chamber to provide an atmosphere of oxygen in the second plasma-processing operation to form the oxide layer.

According to a sixth aspect of the present invention, there is provided a wafer processing apparatus comprising grinding means for grinding an underside of a wafer whose front surface has a plurality of semiconductor devices formed thereon; polishing means for polishing a ground surface formed by the grinding means; and plasma-processing means for carrying out a plasma-processing for a polished surface formed by the polishing operation under a predetermined gaseous atmosphere in a plasma chamber, to roughen the polished surface.

Namely, in the sixth aspect of the present invention, the underside of the wafer is appropriately roughened by plasma-processing and, accordingly, a metal coating coated in a later metalizing process bites into the roughened portion. Thus, the metal coating can be prevented from being stripped even from a thin wafer. Carbon tetrafluoride (CF₄) or sulfur hexafluoride (SF₆) is supplied to the plasma chamber to provide an atmosphere of CF₄ or SF₆ in the plasma-processing operation to roughen the surface.

According to a seventh aspect of the present invention, there is provided a wafer processing apparatus comprising grinding and polishing means for grinding an underside of a wafer which is provided, on its front surface, with a plurality of semiconductor devices and polishing a ground surface formed by the grinding operation; plasma-processing means for carrying out a plasma-processing for a polished surface formed by the polishing operation under a predetermined gaseous atmosphere in a plasma chamber, to form an oxide layer on the polished surface; applying means for applying a DAF tape and/or a dicing tape to the underside of the wafer; and stripping means for stripping the DAF tape and/or the dicing tape or releases thereof from the underside of the wafer, wherein the grinding and polishing means, the plasma-processing means, the applying means and the removing means are integral with one another; and the wafer can be transferred between the grinding and polishing means, the plasma-processing means, the applying means and the stripping means.

Namely, in the seventh aspect of the present invention, time management for grinding and polishing operations in the grinding and polishing means, a plasma-processing operation in the plasma-processing means, an applying operation in the applying means, and a stripping operation in the stripping means, can be controlled together.

### BRIEF DESCRIPTION OF THE DRAWINGS

Fig. 1 is a schematic view of a wafer processing apparatus according to the present invention;
Figs. 2a to 2e are views of processes showing a wafer processing method according to the present invention; and
Fig. 3 is a schematic sectional view of a plasma-processing machine in a wafer processing apparatus according to the present invention.

### DESCRIPTION OF THE PREFERRED EMBODIMENTS

Embodiments of the present invention will be described below with reference to the accompanying drawings. In the following drawings, the same members are designated by the same reference numerals. For ease of understanding, the scale is changed as necessary in the drawings.

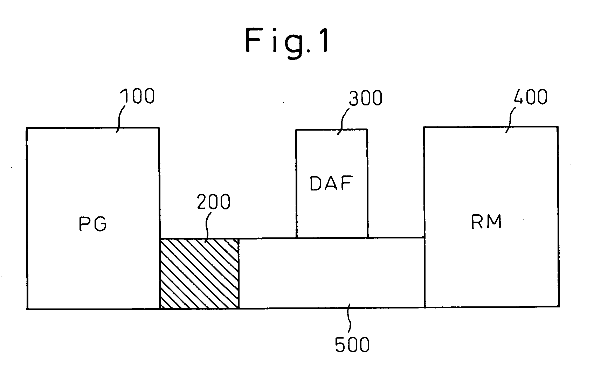

Fig. 1 is a schematic view of a wafer processing apparatus according to the present invention. As shown in Fig. 1, the wafer processing apparatus comprises a grinding and polishing machine 100 capable of grinding and polishing a surface of a wafer and, particularly, an underside of the wafer. Further, as illustrated, a plasma-processing machine 200 is disposed adjacent to the grinding and polishing machine 100. In the plasma-processing machine 200, a desired plasma-processing operation can be carried out for a wafer which has been ground and polished in the grinding and polishing machine 100. The plasma-processing machine 200, which will be described in detail, may be integrally formed with the grinding and polishing machine 100. Even in ether case, a grinding and polishing operation in the grinding and polishing machine 100 and a plasma-processing operation in the plasma-processing machine 200 can be continuously carried out in a line.

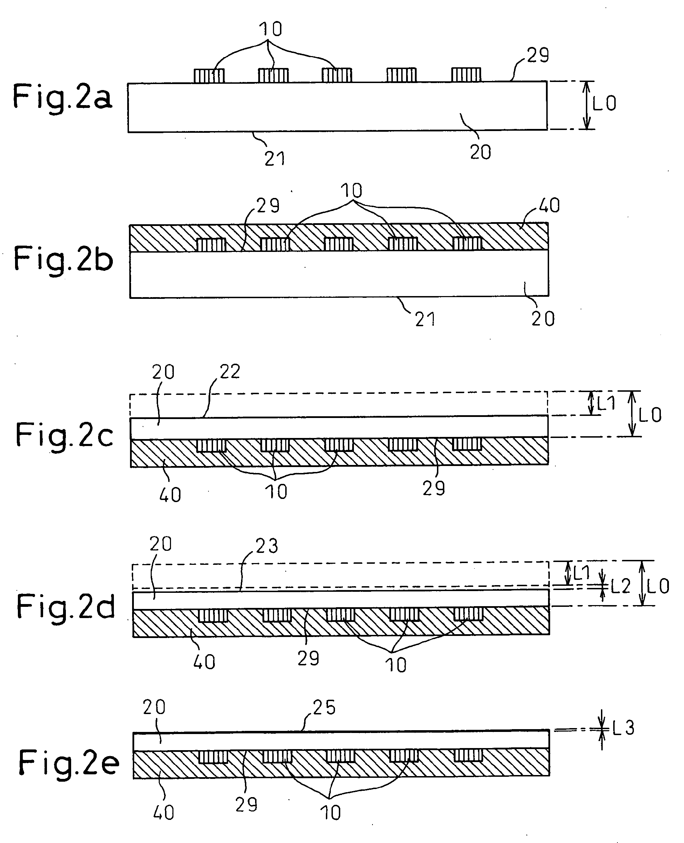

Figs. 2a to 2e show processes of a wafer processing method according to the present invention. A wafer processing method according to the present invention will be described with reference to Figs. 1 and 2. In Fig. 2a, a plurality of semiconductor devices 10 are formed on a front surface (pattern-formed surface) 29 of a wafer 20, for example, a silicon wafer, having a thickness of L0. The semiconductor devices 10 are spaced at equal distances on the pattern-formed surface 29.

As shown in Fig. 2b, a retaining layer 40 suitable for retaining the plural semiconductor devices 10 is formed on the pattern-formed surface 29 (front surface) of the wafer 20 by a retaining layer forming device (not shown). The retaining layer 40 is formed by applying an adhesive resin film to the pattern-formed surface by, for example, a laminating device, or by applying a liquid resin to the pattern-formed surface. As will be described later, the retaining layer 40 protects the semiconductor devices 10 on the pattern-formed surface 29 when grinding and polishing the wafer.

The wafer 20 in the above state is introduced to the grinding and polishing machine 100 of the wafer processing apparatus shown in Fig. 1. The wafer 20 is held by a drawing and holding table (not shown) while the underside 21, on which no semiconductor devices 10 is formed, faces upward. As can be seen from Fig. 2c, the underside 21 of the wafer 20, on which no semiconductor devices 10 is formed, is ground by a grinding machine (not shown) of the grinding and polishing machine 100.
To grind the underside of a wafer as described above is called "back grinding". In the grinding operation of the present invention, the infeed grinding, in which the wafer 20 is drawn and held by a rotatable drawing and holding chuck (not shown) while the pattern-formed surface thereof faces downward and, then, a grinding device is downwardly moved to the underside 21 of the wafer 20, to grind the same, is adopted. As a matter of course, another grinding method, for example, creepfeed grinding, in which a grinding device is rotated while a plurality of substrates are rotated on a table, may be adopted. The retaining layer 40 is provided between the semiconductor devices 10 and a drawing and holding surface of the drawing and holding chuck and, accordingly, the semiconductor devices 10 on the pattern-formed surface 29 of the wafer 20 are not in direct contact with the drawing and holding chuck. Thus, the semiconductor devices 10 can be protected. As shown in Fig. 2c, the underside 21 of the wafer 20 is ground, by a thickness L1, toward the pattern-formed surface 29, by the grinding device and, thus, the thickness of the wafer 20 is reduced. In a ground surface 22 (underside) formed by grinding the underside 21 of the wafer 20, an affected layer, i.e., a brittle fracture layer occurs.

As can be seen from Figs. 2c and 2d, after washing the wafer 20, the wafer 20 is further reduced, by a thickness L2, by polishing the ground surface 22 of the wafer 20. In the present invention, a polishing method, in which a polishing device using a polishing liquid containing a chemical abrasive compound, is adopted. As shown in the drawing, the substrate is polished to only a thickness L2 smaller than the thickness L1, so that the brittle fracture layer in the ground surface 22 is removed. Therefore, the adhesiveness of a semiconductor 11 when the semiconductor is mounted, and the strength of the semiconductor, can be improved. For ease of understanding, the thickness L1 and the thickness L2 are indicated as relatively small dimensions with respect to the thickness L0 in Fig. 2. However, in practice, a polished surface 23 of the wafer 20 obtained after the grinding and polishing operations, is located so close to the pattern-formed surface 29 that ion contamination can occur in normal use.

With reference to Fig. 1, the wafer 20 ground and polished in the grinding and polishing machine 100 is transferred to the plasma-processing machine 200 by a loader etc. (not shown). As illustrated, in the present invention, the plasma-processing machine 200 is disposed adjacent to the grinding and polishing machine 100, or is integrally formed with the grinding and polishing machine 100. Accordingly, the wafer 20 is not exposed to a polluted environment when transferred from the grinding and polishing machine 100 to the plasma-processing machine 200. Therefore, electrical failures in the final semiconductor products, due to the mixing of contamination from a polluted environment, can be reduced.

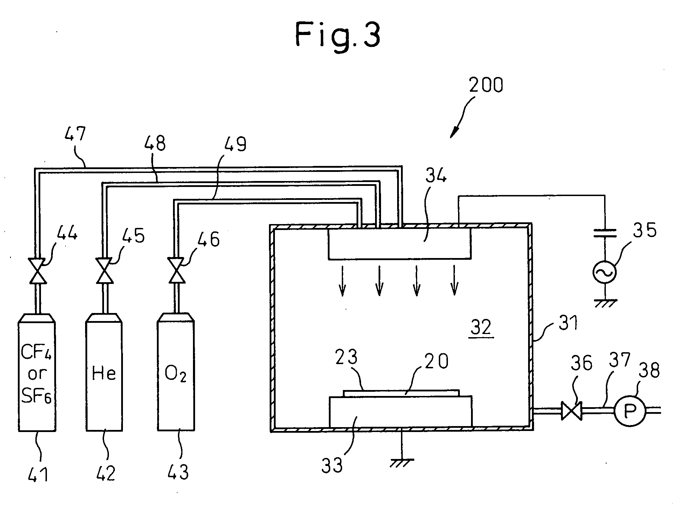

Fig. 3 is a schematic sectional view of a plasma-processing machine in a wafer processing apparatus according to the present invention. As shown in Fig. 3, the plasma-processing machine 200 comprises a plasma chamber 31 in which plasma-processing is actually carried out. An upper planar electrode 34 made of a porous material is provided on the upper portion of an inner space 32 of the plasma chamber 31. A lower planar electrode 33 opposite to the upper planar electrode 34 is provided on the bottom of the inner space 32 of the plasma chamber 31. As shown in the drawing, the upper planar electrode 34 is connected to a power source 35, and the lower planar electrode 33 is grounded. Accordingly, a desired voltage from the power source 35 can be applied between these planar electrodes 34, 33. A source 41 containing one of carbon tetrafluoride (CF₄) and sulfur hexafluoride (SF₆) is connected to the planar electrode 34 via a pipe 47. Likewise, a source 42 containing an inert gas, for example, helium (He) is connected to the planar electrode 34 via a pipe 48, and a source 43 containing oxygen (O₂) is connected to the planar electrode 34 via a pipe 49. As illustrated, these pipes 47, 48 and 49 are provided with open/close valves 44, 45 and 46, respectively. Accordingly, a gas in respective sources 41, 42 and 43 can be supplied to the inner space 32 of the plasma chamber 31, and through the planar electrode 34, as necessary. The open/close valves 44, 45 and 46 are usually closed. In the source 41, fluorinated gas other than CF₄ and SF₆, Br₂ or HBr can be stored. An exhaust pipe 37 extending from the vicinity of the bottom of the plasma chamber 31, is connected to a pump 38, and is provided with a open/close valve 36.

The wafer 20, ground and polished in the grinding and polishing machine 100, is transferred to the plasma chamber 31 though an inlet (not shown) thereof, and is placed on the lower planar electrode 33, with the ground surface 23 being upwardly oriented. Then, the inlet is closed and sealed. The open/close valve 36 is opened, and the pump 38 is activated, to decompress the inner space 32 of the plasma chamber 31 by discharging gas through the pipe 37. Then, the open/close valve 44 is opened to supply CF₄ or SF₆ to the inner space 32 of the plasma chamber 31, and through the planar electrode 34, via the pipe 47. A voltage is applied, by the power source 35, between the lower planar electrode 33 and the upper planar electrode 34, in the plasma chamber 31 which is slightly decompressed. The CF₄ or SF₆ supplied to the plasma chamber 31 functions as a reactive gas and, accordingly, plasma is formed in the inner space 32 of the plasma chamber 31. The plasma is a low temperature plasma having a temperature of about 60 to 90°C and, accordingly, the retaining layer 40 of the wafer 20 is not damaged. The plasma impinges on the polished surface 23 of the wafer 20 by a flow of CF₄ gas or SF₆ gas through the upper planar electrode 34 and, thus, the polished surface 23 is plasma-processed. If, for example, CF₄ is adopted as a reactive gas, the CF₄ is decomposed into carbon trifluoride (CF₃) and fluorine (F), and the F is applied to the polished surface 23 of the wafer 20 made of silicon. On the surface of the wafer 20, silicon (Si) of the wafer 20 reacts with F to form silicon tetrafluoride (SiF₄) and, then, is removed from the polished surface 23 of the wafer 20. Therefore, the underside of the wafer 20 is removed by, for example, about 20Å to 40Å, to produce a new surface of the wafer 20. The same is almost true in other cases in which SF₆, etc. is adopted as a reactive gas. Therefore, an effect similar to that of cleaning of the polished surface can be obtained by such plasma processing. Nitrogen dioxide NO₂ together with CF₄ and SF₆ may be supplied to the plasma chamber 31, as necessary. Thus, a cleaning operation using plasma processing can be efficiently carried out.

After carrying out plasma processing for a predetermined time, the open/close valve 44 is closed, and the pump 38 is activated while the open/close valve 36 is opened, to discharge a gas in the inner space 32, i.e., CF₄, SF₆ or the like. Then, the open/close valve 45 is opened while the open/close valve 36 is closed, to supply an inert gas in the source 42, for example, helium to the inner space 32 of the plasma chamber 31, through the upper planar electrode 34, via the pipe 48. Once the inner space 32 of the plasma chamber 31 is charged with helium, the open/close valve 36 is opened while the open/close valve 45 is closed, to discharge the helium. Thus, the remaining gas such as CF₄ or SF₆ in the inner space 32 of the plasma chamber 31 is almost completely discharged, and the inner space 32 of the plasma chamber 31 can be cleaned.

After closing the open/close valve 36, the open/close valve 46 is opened to supply oxygen in the source 43 to the inner space 32 of the plasma chamber 31, and through the upper planar electrode 34, via the pipe 49. A voltage is applied, by the power source 35, between the lower planar electrode 33 and the upper planar electrode 34, in the plasma chamber 31 which is slightly decompressed. In this case, oxygen functions as a reactive gas and, accordingly, plasma is formed in the inner space 32 of the plasma chamber 31. The plasma is a low temperature plasma having a temperature of about 60 to 90°C and, accordingly, the retaining layer 40 of the wafer 20 is not damaged. The plasma impinges on the polished surface 23 of the wafer 20 by a flow of oxygen gas through the upper planar electrode 34 and, thus, the polished surface 23 is plasma-processed and, thus, an oxide layer is formed on the polished surface 23 of the wafer 20. In Fig. 2e, an oxide layer 25 is formed by plasma processing under an oxygen atmosphere. The oxide layer 25, formed in such a manner, has a thickness L3 of, for example, about 20Å. As described above, in the present invention, the oxide layer 25 can be formed on the underside of the wafer and, accordingly, ion contamination can be prevented from occurring. Also, a wafer can be processed while the occurrence of an electrical failure is reduced, even if the thickness of the wafer is reduced. In contrast to a case in which a natural oxide layer is partially formed on the wafer 20, the oxide layer is positively formed on the entire surface of the wafer 20 in the present invention. Thus, the surface of the wafer can be prevented from being mottled in a later thin film deposition process. Further, in the present invention, both the plasma processing operation under an atmosphere of CF₄ or SF₆ and the plasma processing operation under an atmosphere of O₂ are carried out in the single plasma chamber 31. Accordingly, it is possible to prevent the moving of contamination from a polluted atmosphere to a wafer. Namely, the present invention is different from situations when it is necessary to transfer the wafer from a polishing machine to a plasma processing machine under an atmosphere of CF₄ or SF₆, and when it is necessary to transfer the wafer from a plasma processing machine under an atmosphere of CF₄ or SF₆ to a plasma processing machine under an atmosphere of O₂.

With reference to Fig. 1, the wafer 20 discharged through an outlet (not shown) provided in the plasma chamber 31 of the plasma-processing machine 200 is transferred to a dicing tape applying machine 400 by a transferring machine 500. A dicing tape is applied to the oxide layer 25 on the underside of the wafer 20. The wafer 20 is cut into cubic dies, from the pattern-formed surface 29 of the wafer 20, by a dicing saw and in a dicing apparatus (not shown). In this cutting, the dicing saw cuts halfway through the dicing tape. Thus, the dies are prevented from separating and scattering. After the dicing tape is expanded, each die is picked up from the dicing tape and, then, a die bonding operation is carried out. If the wafer 20 is polished, an adhesion force between the dicing tape and the polished surface 23 is extremely large because the polished surface 23 of the wafer 20 is activated after being polished. Accordingly, it is sometimes difficult to pick up the dies from the dicing tape in the die bonding operation. However, as described above, in the present invention, the oxide layer 25 is formed on the polished surface 23 of the wafer 20 and, accordingly, the adhesion force between the dicing tape and the oxide layer 25 on the underside of the wafer is not so large. Therefore, in the present invention, the dies can be easily picked up from the dicing tape in the die bonding operation.

As illustrated, a die attach film tape (DAF tape) attaching machine 300 may be provided between the plasma-processing machine 200 and the dicing tape applying machine 400. Thus, the DAF tape may be applied to the plasma-processed underside of the wafer 20 and, then, the dicing tape may be applied to the DAF tape in the dicing tape applying machine 400. The DAF tape provided between the dicing tape and the underside of the wafer 20, functions as an adhesive provided on the bottom surface of the die in the die bonding operation.

As described above, in the present invention, the DAF tape applying machine 300 for applying the DAF tape and the dicing tape applying machine 400 for applying the dicing tape are provided adjacent to or integral with the grinding and polishing machine 100 and the plasma-processing machine 200. Thus, the mixing of contamination can be prevented when the wafer is transferred. Further, with the above structure, time management of the grinding and polishing machine 100, of the plasma-processing machine 200, of the DAF tape applying machine 300 and of the dicing tape applying machine 400 can be controlled together. Thus, throughput in all processes can be improved, and a defective fraction can be reduced to a minimum. Further, a tape detaching machine (not shown) for detaching the DAF tape and/or the dicing tape or releases of these tapes, may be provided. Namely, the grinding and polishing machine 100, the plasma-processing machine 200, the DAF tape applying machine 300, the dicing tape applying machine 400 and the tape stripping machine (not shown) may be integral with one another, and the wafer may be freely transferred among the grinding and polishing machine 100, the plasma-processing machine 200, the DAF tape applying machine 300, the dicing tape applying machine 400 and the tape stripping machine, by transferring means (not shown). In such a case, time management of the grinding and polishing machine 100, of the plasma-processing machine 200, of the DAF tape applying machine 300, of the dicing tape applying machine 400 and of the tape stripping machine can be controlled together. Thus, throughput in all processes can be improved, and a defective fraction can be further reduced.

In the above-described embodiments, a cleaning operation for the polished surface 23 of the wafer 20 and a forming operation of an oxide layer have been described. However, the wafer processing apparatus according to the present invention can be used for another application that will be described later. The underside of the wafer, which is ground and polished in the grinding and polishing machine 100 is flattened more than usual. However, if, for example, the underside of the wafer is metalized in a later process, an adhesion force between the polished surface and a metal coating formed by metalizing is reduced and, accordingly, the metal coating may be stripped. However, in the present invention, the wafer 20 discharged from the grinding and polishing machine 100 is transferred to the plasma-processing machine 200 and, then, is placed in the manner described above. The above-described plasma-processing operation (under an atmosphere of CF₄ or SF₆) functioning as a cleaning operation, is carried out for a longer time than the above-described plasma-processing operation. Accordingly, the polished surface 23 of the wafer 20 can be removed so that the wafer has a thickness of, for example, about 2 to 3 micrometer. In this case, the roughness of a new surface precipitated after the plasma-processing operation is larger than that before the plasma-processing operation. Accordingly, the metal coating formed by metalizing, bites into the rough underside of the wafer 20 and, thus, the adhesion force between the metal coating and the polished surface is increased. Therefore, in the present invention, even if the metalizing operation is carried out in a later process, the metal coating of a thin wafer can be prevented from being stripped.

In the embodiment which has been described with reference to Fig. 2, after the polished surface 23 of the wafer 20 is cleaned by plasma-processing under an atmosphere of CF₄ or SF₆, an oxide layer is formed by plasma-processing under an atmosphere of O₂. However, the plasma-processing under an atmosphere of CF₄ or SF₆ is not necessarily needed. It is apparent that the occurrence of ion contamination can be prevented even if only the plasma-processing under an atmosphere of O₂ is carried out to form an oxide layer. Further, the plasma-processing carried out after only one of the grinding operation and the polishing operation, and a combination of the above embodiments are included in the scope of the present invention.

## Claims

1. A wafer processing method comprising the steps of
grinding an underside of a wafer which is provided, on its front surface, with a plurality of semiconductor devices;
polishing a ground surface formed by the grinding operation; and
carrying out a plasma-processing for a polished surface formed by the polishing operation under a predetermined gaseous atmosphere in a plasma chamber, to form an oxide layer on the polished surface.

2. A wafer processing method comprising the steps of
grinding an underside of a wafer which is provided, on its front surface, with a plurality of semiconductor devices;
polishing a ground surface formed by the grinding operation;
carrying out a first plasma-processing for a polished surface formed by the polishing operation under a first gaseous atmosphere in a plasma chamber, to clean the polished surface; and
carrying out a second plasma-processing for the polished surface after the cleaning operation under a second gaseous atmosphere in the plasma chamber, to form an oxide layer on the polished surface.

3. A wafer processing method comprising the steps of
grinding an underside of a wafer which is provided, on its front surface, with a plurality of semiconductor devices;
polishing a ground surface formed by the grinding operation; and
carrying out a plasma-processing for a polished surface formed by the polishing operation under a predetermined gaseous atmosphere in a plasma chamber, to roughen the polished surface.

4. A wafer processing method according to any one of claims 1 to 3, further comprising the step of applying a DAF tape and/or a dicing tape to the underside of the wafer.

5. A wafer processing apparatus comprising
grinding means for grinding an underside of a wafer whose front surface has a plurality of semiconductor devices formed thereon;
polishing means for polishing a ground surface formed by the grinding means; and
plasma-processing means for carrying out a plasma-processing for a polished surface formed by the polishing operation under a predetermined gaseous atmosphere in a plasma chamber, to form an oxide layer on the polished surface.

6. A wafer processing apparatus comprising
grinding means for grinding an underside of a wafer whose front surface has a plurality of semiconductor devices formed thereon;
polishing means for polishing a ground surface formed by the grinding means; and
plasma-processing means in which after a first plasma-processing is carried out for a polished surface formed by the polishing operation under a first gaseous atmosphere in a plasma chamber, to clean the polished surface, a second plasma-processing is carried out for the polished surface under a second gaseous atmosphere in the plasma chamber, to form an oxide layer on the polished surface.

7. A wafer processing apparatus comprising
grinding means for grinding an underside of a wafer whose front surface has a plurality of semiconductor devices formed thereon;
polishing means for polishing a ground surface formed by the grinding means; and
plasma-processing means for carrying out a plasma-processing for a polished surface formed by the polishing operation under a predetermined gaseous atmosphere in a plasma chamber, to roughen the polished surface.

8. A wafer processing apparatus according to any one of claims 5 to 7, further comprising applying means for applying a DAF tape and/or a dicing tape to the underside of the wafer.

9. A wafer processing apparatus comprising
grinding and polishing means for grinding an underside of a wafer which is provided, on its front surface, with a plurality of semiconductor devices and polishing a ground surface formed by the grinding operation;
plasma-processing means for carrying out a plasma-processing for a polished surface formed by the polishing operation under a predetermined gaseous atmosphere in a plasma chamber, to form an oxide layer on the polished surface;
applying means for applying a DAF tape and/or a dicing tape to the underside of the wafer; and
stripping means for stripping the DAF tape and/or the dicing tape or releases thereof from the underside of the wafer, wherein
the grinding and polishing means, the plasma-processing means, the applying means and the removing means are integral with one another; and
the wafer can be transferred among the grinding and polishing means, the plasma-processing means, the applying means and the stripping means.
